# EUROPÄISCHE PATENTSCHRIFT

(11) **EP 0 405 451 B1**
(45) Veröffentlichungstag und Bekanntmachung des Hinweises auf die Patenterteilung: **27.10.1993**
(21) Anmeldenummer: 90112137.6
(22) Anmeldetag: 26.06.1990
(51) Int. Cl.: C23C 16/24, H01L 21/70

(54) **Herstellverfahren für eine polykristalline Siliziumschicht mit definierter Korngrösse und Textur**
Method for producing a polycrystalline silicon layer with definite grain size and texture on a substrat
Procédé pour appliquer une couche de silicium polycristallin à grosseur du grain et texture définie sur un substrat

(30) Priorität: 30.06.1989 DE 3921627
(43) Veröffentlichungstag der Anmeldung: 02.01.1991
(73) Patentinhaber: SIEMENS AKTIENGESELLSCHAFT, 80333 München (DE)
(72) Erfinder: Bertagnolli, Emmerich, Dr., D-8000 München 40 (DE); Kabza, Herbert, Dr., D-8000 München 60 (DE)

(56) Entgegenhaltungen:
- GB-A- 2 191 510
- US-A- 4 634 605
- US-A- 4 715 317
- PATENT ABSTRACT OF JAPAN, unexamined applications, C Sektion, Band 9, Nr. 171, 16. July 1985 THE PATENT OFFICE OF JAPANESE GOVERNMENT, Seite 148 C 291
- Revue de Physique Appliquée, vol. 16, Dez. 1981, p. 657-662; S. Squelard et al.: "Crystallization of phosphor-doped amorphous silicon films prepared by glow discharge decomposition of silane"

## Beschreibung

Herstellverfahren für eine polykristalline Siliziumschicht mit definierter Korngröße und Textur auf einem Substrat

Die Erfindung betrifft ein Herstellverfahren für eine polykristalline Siliziumschicht auf einem Substrat.

Für polykristalline Siliziumschichten gibt es in der Halbleitertechnologie viele Einsatzmöglichkeiten. Sie werden z. B. benötigt für Widerstände aus polykristallinem Silizium in integrierten Schaltkreisen, für Solarzellen und in der SOI-(= Silicon on Insulator = Silizium auf Isolator)-Technik.

Die Verwendung von Widerständen aus polykristallinem Silizium (sog. Poly-Siliziumwiderstände) in integrierten Schaltkreisen erfordert eine zuverlässige Realisierung der Zielparameter der Widerstände. Die Parameter werden durch die Abscheidebedingungen (Kristallinität und Dicke), die Implantationsdosis bzw. die Dotierstoffkonzentration und die Aktivierung bestimmt. Dabei bestimmen die Implantationsdosis und die Aktivierung die Konzentration der chemisch gelösten und elektrisch aktiven Dotierstoffe. Die Wahl der Abscheidebedingungen bestimmt die Kristallinität der Siliziumschicht (s. z. B. T.I.Kamins, J. Electrochem. Soc. 127 (1980) 686, E.Kinsborn et al, Appl. Phys. Lett. 42 (1983) 835, T.McGinn et al, ECS-Meeting (May 1983) 647, F.S.Becker et al, J.Appl. Phys. 56 (1984) 1233).

Eine Möglichkeit zur Herstellung polykristalliner Siliziumschichten besteht in der polykristallinen Abscheidung. Dabei werden die Kornstruktur und Textur durch die Abscheidung selbst festgelegt. Sie werden durch nachfolgende Hochtemperaturschritte im Bereich von 800°C bis 1050°C nicht mehr wesentlich verändert. Dies gilt insbesondere für undotierte und z. B. mit Bor dotierte Schichten; bei Phosphor- oder Arsendotierung kommt es zu einem weiteren Kornwachstum in der Schicht, jedoch hängt dessen Reproduzierbarkeit von den Ausgangsbedingungen (der Abscheidung) ab.

Eine weitere Möglichkeit zur Herstellung polykristalliner Siliziumschichten besteht darin, daß die Schicht zunächst amorph abgeschieden wird und anschließend durch Kristallisation während eines Hochtemperaturschrittes polykristallin wird. Die Kornstruktur und Textur solcher Schichten werden durch die Kristallisation während des Hochtemperaturschritts bestimmt. Nachtemperungen bei geringeren Temperaturen ändern die einmal festgelegte Kornstruktur nicht mehr. Bei sonst gleichen Parametern haben amorph abgeschiedene und anschließend kristallisierte Schichten nur ca. 1/3 des Schichtwiderstandes von polykristallin abgeschiedenen Schichten (s. F.S.Becker et al, J. Appl. Phys. 56 (1984) 1233). Mit amorph abgeschiedenen Schichten können daher gleiche Zielwerte des Widerstandes mit deutlich geringeren Schichtdicken erreicht werden. Dadurch sind amorph abgeschiedene Schichten ein wesentliches Mittel, um Topographieprobleme von integrierten Schaltkreisen zu entschärfen.

Ein Nachteil der amorph abgeschiedenen Schichten ist die extrem große Schwankungsbreite der sich ergebenden Widerstandswerte von mindestens +/- 10 % gegenüber maximal +/-2 % bei polykristallin abgeschiedenen Schichten.

Die Vorteile amorph abgeschiedener Schichten können daher nur in den Teilbereichen der Silizium-Mikroelektronik sinnvoll genützt werden, in denen es nicht auf präzise eingestellte Widerstandswerte der Schichten ankommt.

Es ist bekannt (s. z. B. F.S.Becker et al, J. Appl. Phys. 56 (1984) 1233), daß der Schichtwiderstand und andere elektrische Eigenschaften von polykristallinen Siliziumschichten mit der Kornstruktur und Textur der Schicht korreliert sind.

Der Erfindung liegt daher die Aufgabe zugrunde, ein Herstellverfahren für eine polykristalline Siliziumschicht mit definierter Korngröße und Textur anzugeben, ohne auf die Vorteile amorph hergestellter Schichten zu verzichten.

Diese Aufgabe wird erfindungsgemäß gelöst durch ein Herstellverfahren für eine polykristalline Siliziumschicht auf einem Substrat mit folgenden Schritten:
a) auf das Substrat wird eine amorphe Siliziumschicht abgeschieden,
b) das Substrat mit der amorphen Siliziumschicht wird in einen Ofen eingebracht, in dem eine Anfangstemperatur herrscht, die geringer als die Kristallisationstemperatur von amorphem Silizium ist,
c) nach Einstellung des thermischen Gleichgewichts wird das Substrat mit der amorphen Siliziumschicht im Ofen von der Anfangstemperatur auf eine Zieltemperatur, die größer als die Kristallisationstemperatur ist, kontrolliert aufgeheizt, so daß beim kontrollierten Aufheizen die momentane Temperatur ein vorgegebenes Temperaturprofil durchläuft, wobei die amorphe Siliziumschicht vollständig auskristallisiert und zur polykristallinen Siliziumschicht wird.

Die Erfindung nutzt dabei die Erkenntnis, daß amorphe Schichten thermodynamisch metastabil sind. Das heißt, daß die Schichten bei Zufuhr von Energie, die über einem bestimmten Schwellwert liegt, auskristallisieren. Dabei erfolgt der Phasenübergang amorph/kristallin nicht gleichmäßig im gesamten Volumen, sondern er beginnt zunächst lokal unter Bildung kleiner Kristallitkeime, die sich im weiteren in den amorphen Bereich hinein ausdehnen. Die Kristallisationskinetik zerfällt in die zwei Bereiche: Keimbildung und Kristallitwachstum.

Aus K.Zellama et al, J.Appl.Phys. 50 (1979) 6995, S.Squelard et al, Rev. Phys. Appl. 16 (1981) 657, R. Bisaro et al, Phys. Rev. B. 31 (1985) 3568 ist bekannt, daß bei amorphen Siliziumschichten, die durch Abscheidung aus der Gasphase (CVD) hergestellt wurden, die grenzflächeninduzierte Kristallisation überwiegt, die im wesentlichen an der Grenzfläche Silizium/ Substrat stattfindet. Die Kristallisation beginnt mit Keimbildung an der Grenzfläche Substrat/Silizium und der Ausbildung einer dünnen, polykristallinen Keimschicht entlang der gesamten Grenzfläche. Nach Bildung dieser Keimschicht gibt es keine weitere Keimbildung mehr. Es findet nur mehr das Wachstum der Kristallite zu Lasten der amorphen Schicht statt. Die Wachstumsrichtung verläuft senkrecht zur Schichtebene. Die Kristallisation endet, sobald die Kristallisationsfront die Schichtoberseite erreicht hat.

Da amorphe Schichten bei Zufuhr von genügend Energie auskristallisieren, findet die Kristallisation bei amorphen Schichten, die in einen auf z. B. 800°C vorgeheizten Rohrofen eingefahren werden, schon während des Einfahrvorganges vollständig statt. Dabei läuft der Übergang amorph/kristallin so unkontrolliert ab, daß eine reproduzierbare Einstellung von Kornstruktur und Textur nicht möglich ist. Dies führt zu den beobachteten großen Schwankungen in den resultierenden Schichtwiderständen bei der Herstellung von Widerständen aus polykristallinem Silizium.

Die präzise Einstellung von Schichtwiderständen erfordert einen exakt definierten Kristallisationsschritt.

Im erfindungsgemäßen Verfahren erfolgt die Kristallisation in einem exakt definierten Kristallisationsschritt. Da das Substrat mit der amorphen Siliziumschicht in einen Ofen eingebracht wird, der auf eine Anfangstemperatur vorgeheizt ist, welche geringer als die Kristallisationstemperatur von amorphem Silizium ist, bleibt die amorphe Siliziumschicht während des Einfahrvorganges und während der Einstellung des thermischen Gleichgewichts im Ofen unverändert, d. h. amorph. Nach Einstellung des thermischen Gleichgewichts, d. h. wenn die amorphe Siliziumschicht und das Substrat die Anfangstemperatur des Ofens angenommen haben, wird der Ofen kontrolliert von der Anfangstemperatur auf eine Zieltemperatur aufgeheizt, die größer als die Kristallisationstemperatur ist. Bei dem kontrollierten Aufheizen durchläuft die momentane Temperatur ein vorgegebenes Temperaturprofil, das reproduzierbar ist. Sowohl schnelles als auch langsames Durchlaufen des Temperaturprofils führen zu jeweils reproduzierbarer Textur und Korngröße. Bei einem langsamen Durchlaufen des Temperaturprofils werden größere Kristallite gebildet, während bei einem schnellen Durchlaufen des Temperaturprofils kleinere Kristallite gebildet werden. Der elektrische Widerstand der kristallisierten Proben ist abhängig von der Größe der Kristallite. Kleinere Kristallite bedeuten einen höheren, größere Kristallite einen geringeren Widerstand. Je nach Anwendungsgebiet der polykristallinen Schicht werden durch unterschiedlich schnelles Durchlaufen des Temperaturprofils unterschiedliche Kristallitgrößen und damit unterschiedliche elektrische Parameter erzielt.

Das erfindungsgemäße Herstellverfahren ist geeignet für alle polykristallinen Schichten, bei denen es auf eine definierte Korngröße und Textur ankommt, insbesondere für Widerstände aus polykristallinen Silizium, Anschlüsse aus polykristallinen Silizium, elektrische Verbindungen aus polykristallinem Silizium, in der SOI-(Silicon on Insulator = Silizium auf Isolator)-Technologie und für Solarzellen.

Es liegt im Rahmen der Erfindung, daß das Substrat auf der Zieltemperatur z. B. 15 min getempert wird.

Eine Möglichkeit zur Herstellung der amorphen Siliziumschicht besteht darin, daß sie in einem sog. CVD-Verfahren bei 560°C aus der Gasphase abgeschieden wird. In diesem Fall beträgt die Anfangstemperatur im Ofen 500°C bis 550°C.

Eine weitere Möglichkeit zur Herstellung der amorphen Siliziumschicht besteht darin, daß sie durch Sputtern bei einer Temperatur zwischen z.B. 200°C und 350°C auf dem Substrat abgeschieden wird. Die Anfangstemperatur im Ofen beträgt hier entsprechend 200°C - 350°C.

Durch langsames Hochheizen des Substrats mit der amorphem Siliziumschicht auf die Zieltemperatur von z. B. 700°C mit einer zeitlichen Änderung der Temperatur kleiner/gleich 10°C/min werden z. B. bei einer Schichtdicke von 0,3 µm Korngrößen von etwa 0,3 µm erzielt. Solche polykristalline Siliziumschichten sind, nach entsprechender Dotierung, zur Herstellung von Widerständen aus polykristallinen Silizium geeignet.

Es liegt im Rahmen der Erfindung, die Kristallisation in einem schnellen thermischen Ausheilschritt, einem sog. Rapid-thermal-annealing-Prozeß durchzuführen. In den Rapid-thermal-annealing-Verfahren werden schnelle Temperaturänderungen von mindestens 100°C pro Sec. erzeugt. Typischerweise liegen die Temperaturänderungen im Bereich von einigen 100 °C pro Sec. Zum Heizen werden in diesem Verfahren z. B. Wolframlampen und wassergekühlte Lichtbogenlampen verwendet. Damit werden die Temperaturen im Bereich zwischen 500 °C und 1150 °C erzielt.

Je nach gewünschter elektrischer Leitfähigkeit wird die polykristalline Siliziumschicht dotiert. Die Dotierung geschieht entweder durch Implantation in die polykristalline Siliziumschicht und durch anschließende Aktivierung der Dotierstoffe oder durch Implantation in die amorphe Siliziumschicht vor dem Kristallisationsschritt. Da in amorphen Schichten der Channelling-Effekt, der zu verschmierten Dotierungsprofilen führt, prinzipiell nicht auftritt, ist es vorteilhaft, die Implantation z. B. von Bor in die amorphe Schicht vor dem Kristallisationsschritt vorzusehen. In diesem Fall erfolgt die Aktivierung in einem Hochtemperaturschritt nach dem Kristallisationsschritt.

Eine weitere Möglichkeit besteht darin, den Dotierstoff schon während der amorphen Abscheidung in-situ einzubringen.

Weitere Ausgestaltungen der Erfindung gehen aus den Unteransprüchen hervor.

Im folgenden wird die Erfindung anhand eines Ausführungsbeispiels und der Figuren näher erläutert.

Fig. 1 stellt ein Substrat mit einer amorphen Siliziumschicht dar.

Fig. 2 stellt ein Substrat mit einer polykristallinen Siliziumschicht dar.

Fig. 3 stellt den Schichtwiderstand in Abhängigkeit der Implantationdosis für unterschiedlich behandeltes Polysilizium dar.

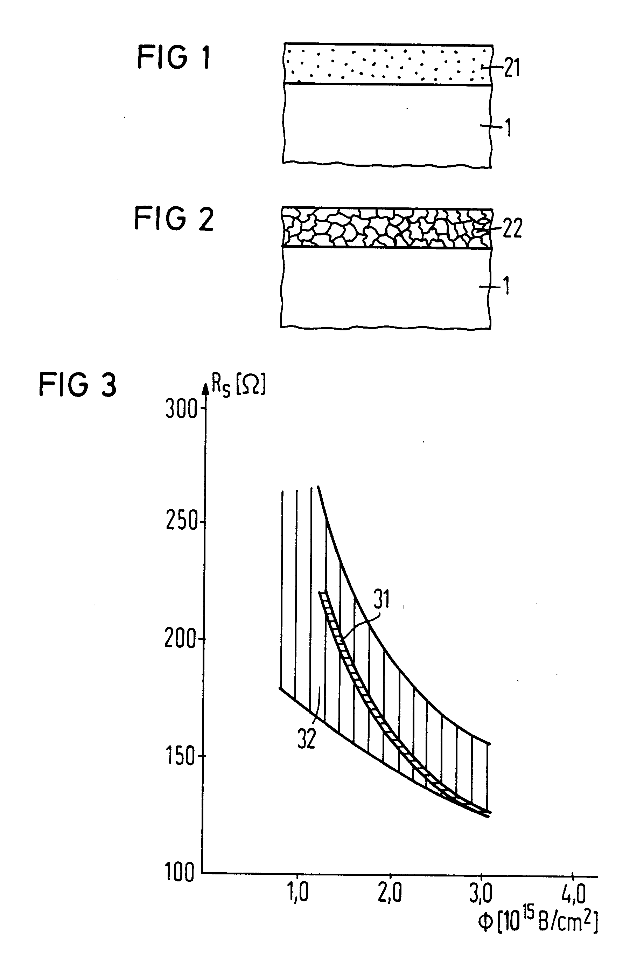

Anhand der Figuren 1 und 2 wird im folgenden ein Ausführungsbeispiel beschrieben. Auf ein Substrat 1 aus z. B. Siliziumdioxid wird eine amorphe Siliziumschicht 21 abgeschieden z. B. durch ein CVD-Verfahren bei 560°C. Die amorphe Siliziumschicht 21 wird durch Implantation oder in-situ Dotierung mit einem Dotierstoff dotiert. Der Dotierstoff ist z. B. Arsen, wenn ein n-Widerstand angestrebt wird, oder Bor, wenn ein p-Widerstand gewünscht ist. Das Substrat 1 mit der amorphen Siliziumschicht 21 wird in einen Ofen eingebracht, der auf eine Anfangstemperatur vorgeheizt ist. Die Anfangstemperatur muß deutlich unterhalb der Kristallisationstemperatur liegen. Wenn z. B. die amorphe Siliziumschicht 21 bei einer Temperatur von 560°C auf dem Substrat 1 abgeschieden wurde, ist es sinnvoll, als Anfangstemperatur eine Temperatur in diesem Bereich zu wählen. Die Anfangstemperatur im Ofen beträgt dann z. B. kleiner/gleich 560°C.

Nach der Einstellung des thermischen Gleichgewichts bei der Anfangstemperatur im Ofen, d. h. wenn das Substrat 1 und die amorphe Schicht 21 die Anfangstemperatur angenommen haben, wird die Ofentemperatur von der Anfangstemperatur auf eine Zieltemperatur geändert. Die Zieltemperatur liegt oberhalb der Kristallisationstemperatur, z. B. bei 700°C. Die Temperaturänderung erfolgt entsprechend einem Temperaturprofil z. B. mit einer Änderungsrate kleiner/gleich 10°C pro Minute. Mit diesen Parametern werden Kristallitgrößen erzielt, wie sie den Zielparametern für Widerstände aus polykristallinem Silizium entsprechen.

Bei der Kristallisation kommt es an der Grenzfläche zwischen dem Substrat 1 und der amorphen Siliziumschicht 21 zur Keimbildung und anschließend zum Kristallitwachstum. Dadurch entsteht aus der amorphen Schicht 21 eine polykristalline Siliziumschicht 22 (s. Fig. 1, Fig. 2). Es liegt im Rahmen der Erfindung, das Substrat auf der Zieltemperatur z. B. 15 Minuten zu tempern, um sicher zu gehen, daß der Kristallisationsvorgang vollständig abgeschlossen wird.

Nach Beendigung des Temperzyklus' werden die Dotierstoffe durch einen Hochtemperaturschritt aktiviert. Als Hochtemperaturschritt ist z. B. ein Ofenprozeß bei 900°C während 8 Minuten oder z. B. ein schnelles Temperverfahren (Rapid thermal annealing RTA) bei 1050°C während 10 sec. geeignet. Da schnelle Temperschritte zu einem sehr hohen elektrischen Aktivierungsgrad führen (s. H.J.Böhm et al, Proceedings of the 1^{st} Int. Symp. on ULSI Science and Technology 1987, p. 347, May 1987, Philadelphia), sind diese den Ofenprozessen vorzuziehen.

In Fig. 3 sind der Schichtwiderstand Rₛ in Abhängigkeit der Implantationsdosis φ für verschiedene Polysilizium-Widerstände dargestellt. Eine erste Kurve 31 bezeichnet den Ort der Schichtwiderstände als Funktion der Implantationsdosis von polykristallinen Siliziumwiderständen, die nach dem Verfahren gemäß der Erfindung hergestellt wurden. Dabei wurde die amorphe Siliziumschicht bei 560°C abgeschieden. Die Anfangstemperatur für den Kristallisationsprozeß beträgt 450°C, die Zieltemperatur im Ofen beträgt 800°C. Die elektrische Aktivierung der Dotierstoffe erfolgte bei 950°C. In Fig. 3 ist eine Kurve 32 dargestellt, die den Ort der Schichtwiderstände als Funktion der Implantationsdosis für Polysiliziumwiderstände darstellt, die nach einem konventionellen Verfahren erzeugt wurden. Diese Polysiliziumwiderstände wurden als amorphe Siliziumschichten abgeschieden, die während der elektrischen Aktivierung unkontrolliert auskristallisiert sind. Der Vergleich der ersten Kurve 31 mit der zweiten Kurve 32 zeigt deutlich, daß die Streuung der Schichtwiderstandswerte durch die Herstellung nach dem erfindungsgemäßen Verfahren drastisch reduziert wird. Fig. 3 zeigt weiter, daß eine genaue Einstellung des Schichtwiderstandes eines Polysiliziumwiderstandes, der nach einem konventionellen Verfahren hergestellt wurde, unmöglich ist.

## Patentansprüche

1. Herstellverfahren für eine polykristalline Siliziumschicht auf einem Substrat mit folgenden Schritten:
(a) auf das Substrat (1) wird eine amorphe Siliziumschicht (21) abgeschieden,
(b) das Substrat (1) mit der amorphen Siliziumschicht (21) wird in einen Ofen eingebracht, in dem eine Anfangstemperatur herrscht, die geringer als die Kristallisationstemperatur von amorphem Silizium ist,
(c) nach Einstellung des thermischen Gleichgewichts wird das Substrat (1) mit der amorphen Siliziumschicht (21) im Ofen von der Anfangstemperatur auf eine Zieltemperatur, die größer als die Kristallisationstemperatur ist, kontrolliert aufgeheizt, so daß beim kontrollierten Aufheizen die momentane Temperatur ein vorgegebenes Temperaturprofil durchläuft, wobei die amorphe Siliziumschicht (21) vollständig auskristallisiert und zur polykristallinen Siliziumschicht (22) wird.

2. Herstellverfahren nach Anspruch 1,
**dadurch gekennzeichnet**, daß das Substrat (1) auf der Zieltemperatur getempert wird.

3. Herstellverfahren nach Anspruch 2,
**dadurch gekennzeichnet**, daß das Tempern bei der Zieltemperatur während 15 Minuten erfolgt.

4. Herstellverfahren nach einem der Ansprüche 1 bis 3,
**dadurch gekennzeichnet**, daß die amorphe Siliziumschicht (21) in einem CVD-Verfahren bei 560°C bis 600°C abgeschieden wird und die Anfangstemperatur 500°C bis 550°C beträgt.

5. Herstellverfahren nach einem der Ansprüche 1 bis 3,
**dadurch gekennzeichnet**, daß die amorphe Siliziumschicht (21) durch Sputtern abgeschieden wird.

6. Herstellverfahren nach einem der Ansprüche 1 bis 5,
**dadurch gekennzeichnet**, daß die Zieltemperatur 700°C bis 800°C beträgt.

7. Herstellverfahren nach einem der Ansprüche 1 bis 6,
**dadurch gekennzeichnet**, daß das Aufheizen von der Anfangstemperatur zur Zieltemperatur mit einer zeitlichen Änderung der Temperatur kleiner/gleich 10°C pro Minute erfolgt.

8. Herstellverfahren nach einem der Ansprüche 1 bis 6,
**dadurch gekennzeichnet**, daß das Aufheizen von der Anfangstemperatur zur Zieltemperatur in einem schnellen Ausheilverfahren (Rapid thermal annealing) mit einer Temperaturänderung von mindestens 100°C pro Sec. erfolgt.

9. Herstellverfahren nach einem der Ansprüche 1 bis 8,
**dadurch gekennzeichnet**, daß die amorphe Siliziumschicht (21) nach ihrer Abscheidung durch Implantation dotiert wird.

10. Herstellverfahren nach einem der Ansprüche 1 bis 8,
**dadurch gekennzeichnet**, daß die polykristalline Siliziumschicht (22) durch Implantation dotiert wird.

11. Herstellverfahren nach einem der Ansprüche 1 bis 8,
**dadurch gekennzeichnet**, daß die amorphe Siliziumschicht (21) während des Abscheideprozesses in-situ dotiert wird.

12. Herstellverfahren nach einem der Ansprüche 9, 10 oder 11,
**dadurch gekennzeichnet**, daß die Dotierstoffe durch einen Hochtemperaturschritt aktiviert werden, der nach der Umwandlung der amorphen Siliziumschicht (21) in die polykristalline Siliziumschicht (22) erfolgt.

13. Verwendung eines Herstellverfahrens nach einem der Ansprüche 1 bis 12 zur Erzeugung von Polysiliziumwiderständen in einem integrierten Schaltkreis.

## Claims

1. Method of production of a polycrystalline silicon layer on a substrate, comprising the following steps:
a) an amorphous silicon layer (21) is deposited on the 5 substrate (1),
b) the substrate (1) having the amorphous silicon layer (21) is introduced into a furnace in which an initial temperature prevails which is less than the crystallisation temperature of amorphous silicon,
c) after establishing the thermal equilibrium, the substrate (1) having the amorphous silicon layer (21) is heated in a controlled manner in the furnace from the initial temperature to a target temperature which is higher than the crystallisation temperature 15 so that, during the controlled heating, the instantaneous temperature traverses a specified temperature profile, in which process the amorphous silicon layer (21) crystallises completely and becomes a polycrystalline silicon layer (22).

2. Method of production according to Claim 1, characterised in that the substrate (1) is baked at the target temperature.

3. Method of production according to Claim 2, characterised in that the baking is carried out at the 25 target temperature for 15 minutes.

4. Method of production according to one of Claims 1 to 3, characterised in that the amorphous silicon layer (21) is deposited in a CVD process at 560°C to 600°C and the initial temperature is 500°C to 550°C.

5. Method of production according to one of Claims 1 to 3, characterised in that the amorphous silicon layer (21) is deposited by sputtering.

6. Method of production according to one of Claims 1 to 5, characterised in that the target temperature is 700°C to 800°C.

7. Method of production according to one of Claims 1 to 6, characterised in that the heating from the initial temperature to the target temperature is carried out with a change in the temperature with respect to time which is less than/equal to 10°C per minute.

8. Method of production according to one of Claims 1 to 6, characterised in that the heating from the initial temperature to the target temperature is carried out in a rapid thermal annealing process with a temperature change of not less than 100°C per sec.

9. Method of production according to one of Claims 1 to 8, characterised in that the amorphous silicon layer (21) is doped by implantation after it has been deposited.

10. Method of production according to one of Claims 1 to 8, characterised in that the polycrystalline silicon layer (22) is doped by implantation.

11. Method of production according to one of Claims 1 to 8, characterised in that the amorphous silicon layer (21) is doped in situ during the deposition process.

12. Method of production according to one of Claims 9, 10 or 11, characterised in that the dopants are activated by a high-temperature step which is carried out after the conversion of the amorphous silicon layer (21) into the polycrystalline silicon layer (22).

13. Use of a method of production according to one of Claims 1 to 12 to manufacture polysilicon resistors in an integrated circuit.

## Revendications

1. Procédé de préparation d'une couche de silicium polycristallin sur un substrat comprenant les stades suivants:
a) une couche de silicium (21) amorphe est déposée sur le substrat (1),
b) le substrat (1) ayant la couche de silicium (21) amorphe est introduit dans un four dans lequel règne une température initiale inférieure à la température de cristallisation du silicium amorphe,
c) après que l'équilibre thermique s'est établi, le substrat (1) ayant la couche de silicium (21) amorphe est porté de manière contrôlée dans le four de la température initiale à une température visée supérieure à la température de cristallisation, de sorte que pendant le chauffage contrôlé la température instantanée décrit un profil de température prescrit, la couche de silicium (21) amorphe cristallisant entièrement et devenant une couche de silicium (22) polycristallin.

2. Procédé suivant la revendication 1,
caractérisé en ce que le substrat (1) est recuit jusqu'à la température visée.

3. Procédé suivant la revendication 2,
caractérisé en ce que le recuit à la température visée s'effectue pendant 15 minutes.

4. Procédé suivant l'une des revendications 1 à 3, caractérisé en ce que la couche de silicium (21) amorphe est déposée par un procédé de dépôt chimique en phase vapeur entre 560°C et 600°C et la température initiale est comprise entre 500°C et 550°C.

5. Procédé suivant l'une des revendications 1 à 3,
caractérisé en ce que la couche de silicium (21) amorphe est déposée par pulvérisation cathodique.

6. Procédé suivant l'une des revendications 1 à 5,
caractérisé en ce que la température visée est comprise entre 700°C et 800°C.

7. Procédé suivant l'une des revendications 1 à 6,
caractérisé en ce que le chauffage de la température initiale à la température visée s'effectue avec une variation de la température dans le temps inférieure ou égale à 10°C/minute.

8. Procédé suivant l'une des revendications 1 à 6,
caractérisé en ce que le chauffage de la température initiale à la température visée s'effectue par un procédé rapide de recuit (Rapid thermal annealing) avec une variation de température d'au moins 100°C/seconde.

9. Procédé suivant l'une des revendications 1 à 8,
caractérisé en ce que la couche de silicium (21) amorphe est dopée par implantation après son dépôt.

10. Procédé suivant l'une des revendications 1 à 8,
caractérisé en ce que la couche de silicium (22) polycristalline est dopée par implantation.

11. Procédé suivant l'une des revendications 1 à 8,
caractérisé en ce que la couche de silicium (21) amorphe est dopée in situ pendant le processus de dépôt.

12. Procédé suivant l'une des revendications 9, 10 ou 11,
caractérisé en ce que la substance de dopage est activée par un stade à haute température qui s'effectue après la transformation de la couche de silicium (21) amorphe en la couche de silicium (22) polycristalline.

13. Utilisation d'un procédé de préparation suivant l'une des revendications 1 à 12, pour produire des résistances en polysilicium dans un circuit intégré.
